# EUROPEAN PATENT APPLICATION

(11) **EP 4 787 747 A1**
(43) Date of publication of application: **05.08.2026**
(21) Application number: 24884083.7
(22) Date of filing: 05.08.2024
(51) Int. Cl.: H04L 1/00, H03M 13/13, H04L 1/20

(54) **DECODING METHOD AND APPARATUS**

(30) Priority: 02.11.2023 CN 202311453424
(71) Applicant: Honor Device Co., Ltd., Shenzhen, Guangdong 518040 (CN)
(72) Inventor: ZHONG, Haijing, Shenzhen, Guangdong 518040 (CN); PANG, Gaokun, Shenzhen, Guangdong 518040 (CN)
(74) Representative: Isarpatent
(86) International application number: PCT/CN2024/109755
(87) International publication number: WO 2025/092076

(57) **Abstract**

Embodiments of this application provide a decoding method and an apparatus, applied to a receiving end device. A control channel is established between the receiving end device and a sending end device, and the decoding method includes: receiving a demodulation reference signal sent by the sending end device through the control channel; estimating channel quality of the control channel according to the demodulation reference signal; selecting a first decoding algorithm when the channel quality of the control channel meets a first condition; and selecting a second decoding algorithm when the channel quality of the control channel meets a second condition, where the channel quality meeting the first condition is better than the channel quality meeting the second condition, a decoding delay of the first decoding algorithm is less than a decoding delay of the second decoding algorithm, and decoding reliability of the first decoding algorithm is less than decoding reliability of the second decoding algorithm, so that a decoding algorithm is adaptively selected according to the channel quality of the control channel, to improve decoding reliability and reduce a decoding delay, so as to improve communication reliability.

## Description

This application claims priority to Chinese Patent Application No. 2023114534249, filed with the China National Intellectual Property Administration on November 2, 2023 and entitled "DECODING METHOD AND APPARATUS", which is incorporated herein by reference in its entirety.

### TECHNICAL FIELD

This application relates to the field of communication technologies, and in particular, to a decoding method and an apparatus.

### BACKGROUND

A channel encoding algorithm is one of core technologies in the communication field. A sending end device (briefly referred to as a sending end) adds a check bit to a sent information bit by using the channel coding algorithm, to obtain a bit sequence. After receiving the bit sequence, a receiving end device (briefly referred to as a receiving end) decodes the bit sequence by using a decoding algorithm. After decoding is completed, the receiving end checks a decoding result, and if the check succeeds, determines that decoding on the bit sequence succeeds; or if the check fails, determines that decoding on the bit sequence fails. Therefore, how to select a decoding algorithm is a problem that needs to be resolved urgently currently.

### SUMMARY

This application provides a decoding method and an apparatus. The decoding method and the apparatus can adaptively select a decoding algorithm according to channel quality of a control channel, to improve decoding reliability and reduce a decoding delay, so as to improve communication reliability. To achieve the foregoing objectives, this application provides the following technical solutions:

According to a first aspect, this application provides a decoding method, applied to a receiving end device, where a control channel is established between the receiving end device and a sending end device, and the decoding method includes: receiving a demodulation reference signal sent by the sending end device through the control channel; estimating channel quality of the control channel according to the demodulation reference signal; selecting a first decoding algorithm when the channel quality of the control channel meets a first condition; and selecting a second decoding algorithm when the channel quality of the control channel meets a second condition, where channel quality meeting the first condition is better than channel quality meeting the second condition, a decoding delay of the first decoding algorithm is less than a decoding delay of the second decoding algorithm, and decoding reliability of the first decoding algorithm is less than decoding reliability of the second decoding algorithm, so that a decoding algorithm is adaptively selected according to the channel quality of the control channel.

In this embodiment, a manner of adaptively selecting the decoding algorithm is: when the channel quality of the control channel meets the first condition (that is, the channel quality is better/good), the first decoding algorithm whose decoding reliability is poor but decoding delay is small is selected; and when the channel quality of the control channel meets the second condition (that is, the channel quality is poor), the second decoding algorithm whose decoding reliability is good but decoding delay is large is selected. Although the decoding reliability of the first decoding algorithm is poor, when the channel quality is relatively good, a quantity of pieces of error information in a bit sequence is relatively small, so that the error information can be corrected in time by using the first decoding algorithm. In this way, when the channel quality is relatively good, the decoding reliability can be ensured and the decoding delay can be reduced. Although the decoding delay of the second decoding algorithm is large, the decoding reliability of the second decoding algorithm is good, so that the error information in the bit sequence can be corrected in time by using the second decoding algorithm, and decoding can be completed in a relatively short time. In this way, when the channel quality is relatively poor, the decoding reliability is improved and the decoding delay is reduced. Therefore, the receiving end device can improve the decoding reliability and reduce the decoding delay by adaptively selecting the decoding algorithm, thereby improving the communication reliability.

In a possible implementation, the method further includes: when the channel quality of the control channel meets the first condition, selecting, according to the channel quality of the control channel, a maximum quantity of iterations of decoding of the first decoding algorithm, to select the maximum quantity of iterations of decoding matching the channel quality of the control channel, and properly use the first decoding algorithm to improve a decoding success rate.

In a possible implementation, a relationship between the channel quality of the control channel and the maximum quantity of iterations of decoding is negative correlation. The negative correlation may be that better channel quality of the control channel indicates a smaller maximum quantity of iterations of decoding. When the channel quality is better, the quantity of pieces of error information in the bit sequence is smaller, and when the quantity of pieces of error information in the bit sequence is smaller, the receiving end device can correct the error information by invoking the first decoding algorithm for a relatively small quantity of times. Therefore, when the channel quality of the control channel is better, the maximum quantity of iterations of decoding selected by the receiving end device may be smaller, and when the channel quality of the control channel is worse, the maximum quantity of iterations of decoding selected by the receiving end device may be larger. According to the relationship between the channel quality and the maximum quantity of iterations of decoding, the receiving end device may select, according to the channel quality, the maximum quantity of iterations of decoding matching the channel quality, so that the receiving end device can properly invoke the first decoding algorithm. Therefore, decoding is successfully performed as much as possible when the first decoding algorithm is invoked, and when the channel quality is better, the receiving end device can complete decoding by using as few iterations as possible, thereby improving the decoding reliability and reducing the decoding delay.

In a possible implementation, the method further includes: selecting the second decoding algorithm when a quantity of iterations of invoking the first decoding algorithm by the receiving end device is equal to the maximum quantity of iterations of decoding and decoding fails. In a process in which the receiving end device invokes the first decoding algorithm for decoding, the receiving end device may perform decoding by using a first processor. If the quantity of iterations reaches (is equal to) the maximum quantity of iterations of decoding and decoding fails, the receiving end device may select the second decoding algorithm with relatively good decoding reliability and perform decoding by using the second decoding algorithm, to successfully perform decoding by using the second decoding algorithm as much as possible.

In a possible implementation, the receiving end device includes a first processor and a second processor, a computing capability of the first processor is less than a computing capability of the second processor, and the method further includes: when the quantity of iterations of invoking the first decoding algorithm by the receiving end device is equal to the maximum quantity of iterations of decoding and decoding fails, invoking, by the first processor, the second decoding algorithm for decoding, where a maximum search width of the second decoding algorithm is a default search width. The default maximum search width is used when the second decoding algorithm is invoked. That is, if the second decoding algorithm is invoked after the first decoding algorithm fails, the maximum search width of the second decoding algorithm may be fixed and does not vary with the channel quality. A scenario in which the second decoding algorithm is invoked after the first decoding algorithm fails is: in a scenario in which channel quality is relatively good, a quantity of pieces of error information in a bit sequence is relatively small in this scenario. Therefore, the receiving end device does not need to use the relatively complex second decoding algorithm. In this case, the default maximum search width of the second decoding algorithm may use a relatively small value. For example, the default maximum search width may be 1. In addition, the receiving end device may complete decoding by using the first processor, and the first processor invokes the second decoding algorithm for decoding, thereby reducing occupation of the second processor.

In a possible implementation, the method further includes: when the channel quality of the control channel meets the second condition, selecting the maximum search width of the second decoding algorithm according to the channel quality of the control channel, to properly use the second decoding algorithm to improve the decoding success rate.

In a possible implementation, a relationship between the channel quality of the control channel and the maximum search width is a negative correlation. The negative correlation may be that better channel quality of the control channel indicates a smaller maximum search width. To be specific, when the channel quality is worse, the quantity of pieces of error information in the bit sequence includes is larger, and the maximum search width of the second decoding algorithm needs to be larger. In this way, a possibility of successful decoding of the second decoding algorithm is larger. Therefore, when the channel quality is better, the maximum search width selected by the receiving end device is smaller, and when the channel quality is worse, the maximum search width selected by the receiving end device is larger. According to the relationship between the channel quality and the maximum search width, the receiving end device may select, according to the channel quality, the maximum search width matching the maximum search width, so that the receiving end device can properly invoke the second decoding algorithm, to successfully perform decoding as much as possible when the second decoding algorithm is invoked.

In a possible implementation, the receiving end device includes the first processor and the second processor, the computing capability of the first processor is less than a computing capability of the second processor, and the method further includes: determining, in the first processor and the second processor according to the maximum search width of the second decoding algorithm, a processor that invokes the second decoding algorithm. The maximum search width may be a quantity of candidate paths reserved when the receiving end device invokes the second decoding algorithm for decoding. The receiving end device may select, from the quantity of candidate paths, a path having a smallest path metric value as a unique path, and marks of edges from a root node to a last leaf node in the unique path form a decoding result of the second decoding algorithm. Therefore, a larger maximum search width indicates a larger computing capability required by the second decoding algorithm, and a smaller maximum search width indicates a smaller computing capability required by the second decoding algorithm. According to this rule, the receiving end device may determine, in the first processor and the second processor according to the maximum search width, the processor that invokes the second decoding algorithm.

In a possible implementation, the determining, in the first processor and the second processor according to the maximum search width of the second decoding algorithm, a processor that invokes the second decoding algorithm includes: determining, when the maximum search width of the second decoding algorithm is greater than a preset value, that the second processor invokes the second decoding algorithm; or determining, when the maximum search width of the second decoding algorithm is less than or equal to the preset value, that the first processor invokes the second decoding algorithm. In this way, when the maximum search width is relatively large, the receiving end device invokes the second decoding algorithm by using the second processor, to accelerate a decoding process by using the second processor having a relatively large computing capability, so as to complete decoding as soon as possible.

In a possible implementation, the method further includes at least one of the following: the receiving end device is a terminal, and the control channel is a physical downlink control channel; or the receiving end device is a network side device, and the control channel is a physical uplink control channel; or the channel quality of the control channel is represented by using a signal to interference plus noise ratio of the control channel; or the first decoding algorithm is a belief propagation decoding algorithm; or the second decoding algorithm is a successive cancellation list decoding algorithm.

In a possible implementation, the selecting a first decoding algorithm when the channel quality of the control channel meets a first condition, and selecting a second decoding algorithm when the channel quality of the control channel meets a second condition includes: selecting the belief propagation decoding algorithm when the signal to interference plus noise ratio of the control channel is greater than or equal to a preset threshold; or selecting the successive cancellation list decoding algorithm when the signal to interference plus noise ratio of the control channel is less than the preset threshold. In this embodiment, a larger signal to interference plus noise ratio of the control channel indicates better channel quality of the control channel, a smaller signal to interference plus noise ratio of the control channel indicates poorer channel quality of the control channel. According to a relationship between the signal to interference plus noise ratio and the channel quality, the receiving end device may set the preset threshold. The first condition and the second condition are set by using the preset threshold. For example, the first condition may be that the signal to interference plus noise ratio of the control channel is greater than or equal to the preset threshold, and the second condition may be that the signal to interference plus noise ratio of the control channel is less than the preset threshold. Therefore, the receiving end device may adaptively select the decoding algorithm according to a relationship between the signal to interference plus noise ratio of the control channel and the preset threshold.

In a possible implementation, the method further includes: determining a maximum quantity of iterations of decoding of the belief propagation decoding algorithm according to the signal to interference plus noise ratio of the control channel when the signal to interference plus noise ratio of the control channel is greater than or equal to the preset threshold, so that the receiving end device may select the maximum quantity of iterations of decoding of the belief propagation decoding algorithm in a table look-up manner, to simplify a decoding algorithm selection process and reduce complexity; and/or determining a maximum search width of the successive cancellation list decoding algorithm according to the signal to interference plus noise ratio of the control channel when the signal to interference plus noise ratio of the control channel is less than the preset threshold.

In a possible implementation, a preset correspondence table may be searched for the maximum quantity of iterations of decoding according to the signal to interference plus noise ratio of the control channel; and/or the preset correspondence table may be searched for the maximum search width according to the signal to interference plus noise ratio of the control channel. Therefore, the receiving end device may select the maximum search width of the successive cancellation list decoding algorithm in a table look-up manner, to simplify the decoding algorithm selection process and reduce complexity.

In a possible implementation, the receiving end device includes the first processor and the second processor, the computing capability of the first processor is less than the computing capability of the second processor, and the method further includes: determining, when the maximum search width of the successive cancellation list decoding algorithm is greater than the preset value, that the second processor invokes the successive cancellation list decoding algorithm; or determining, when the maximum search width of the successive cancellation list decoding algorithm is less than or equal to the preset value, that the first processor invokes the successive cancellation list decoding algorithm. The preset value may be a maximum search width used when the receiving end device does not perform acceleration processing on the decoding process. Therefore, when the maximum search width is greater than the preset value, the receiving end device may invoke the successive cancellation list decoding algorithm by using the second processor, to perform acceleration processing on the decoding process. When the maximum search width is less than or equal to the preset value, the receiving end device may invoke the successive cancellation list decoding algorithm by using the first processor, and does not perform acceleration processing on the decoding process.

In a possible implementation, the first processor is a central processing unit, and the second processor is a co-processor.

In a possible implementation, the co-processor is any one of a graphics processing unit, a field programmable gate array circuit, a digital signal processor, and an application-specific integrated circuit.

According to a second aspect, this application provides a receiving end device. The receiving end device includes one or more processors and a memory, where the memory is configured to store computer program code, the computer program code includes computer instructions, and when the one or more processors execute the computer instructions, the receiving end device is caused to performed the foregoing decoding method. The receiving end device may be a terminal or a network side device.

According to a third aspect, this application provides a computer-readable storage medium, where the computer-readable storage medium is configured to store a computer program, and the computer program, when being executed, implements the foregoing decoding method.

According to a fourth aspect, this application provides a chip system, applied to a receiving end device, where the chip system includes at least one processor and an interface, the interface is configured to receive instructions, and transmit the instructions to at least one processor, and the at least one processor runs the instructions, so that the receiving end device performs the foregoing decoding method.

### BRIEF DESCRIPTION OF DRAWINGS

FIG. 1 is a schematic diagram of a decoding method according to an embodiment of this application;
FIG. 2 is a schematic diagram of another decoding method according to an embodiment of this application;
FIG. 3 is a schematic diagram of a structure of a communication apparatus according to an embodiment of this application;
FIG. 4 is a diagram of a hardware structure of a terminal according to an embodiment of this application;
FIG. 5 is a flowchart of a decoding method according to an embodiment of this application; and
FIG. 6 is a flowchart of another decoding method according to an embodiment of this application.

### DESCRIPTION OF EMBODIMENTS

The following clearly and completely describes technical solutions in the embodiments of this application with reference to the accompanying drawings in the embodiments of this application. The terms used in the following embodiments are merely used for describing specific embodiments, and are not intended to limit this application. As used in the specification and the appended claims of this application, singular expressions "one", "a", "the", "the foregoing", "this" and "the one" are also intended to include an expression such as "one or more", unless contrary indication is clearly specified in the context. It should be further understood that in the embodiments of this application, "one or more" means one, two, or more than two; and "and/or" describes an association relationship between associated objects and indicates that three relationships may exist. For example, A and/or B may indicate the following cases: Only A exists, both A and B exist, and only B exists, where A and B may be singular or plural. The character "/" typically represents that the associated object is in an "or" relationship.

As described in this specification, referring to "one embodiment" or "some embodiments" or the like means that one or more embodiments of this application include particular features, structures, or characteristics described with reference to the embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. Terms "comprise", "include", "have", and their variants all mean "include but are not limited to", unless otherwise specifically emphasized in another manner.

In the embodiments of this application, "a plurality of" means "greater than or equal to two". It should be noted that in the description of the embodiments of this application, words such as "first" and "second" are merely used for distinguishing, and cannot be understood as an indication or implication of relative importance or an indication or implication of a sequence.

A bit sequence sent by a sending end includes information sending bit and check bit; a receiving end decodes the bit sequence by using a decoding algorithm; after decoding is completed, the receiving end checks a decoding result; and if the check succeeds, it is determined that the bit sequence is successfully decoded. If the check fails, it is determined that decoding of the bit sequence fails, so that error information generated in a transmission process of the bit sequence is corrected by using the decoding algorithm. Using an example in which a control command such as signaling is transmitted between the sending end and the receiving end through a control channel, the control command may be encapsulated in the bit sequence. After receiving the bit sequence, the receiving end decodes the bit sequence by using a polar code (Polar code) decoding algorithm.

The polar code decoding algorithm includes a successive cancellation list (Successive Cancellation List, SCL) decoding algorithm and a belief propagation (Belief Propagation, BP) decoding algorithm. The SCL decoding algorithm is a successive algorithm, and decoding is performed bit by bit according to a search width L of the SCL decoding algorithm. When a code length is limited, the SCL decoding algorithm can obtain a good decoding reliability but a high decoding delay, reducing throughput. The BP decoding algorithm belongs to parallel decoding, and has a relatively low decoding delay. However, decoding reliability is worse than (less than) decoding reliability of the SCL decoding algorithm, and the decoding reliability may be indicated by using a block error rate.

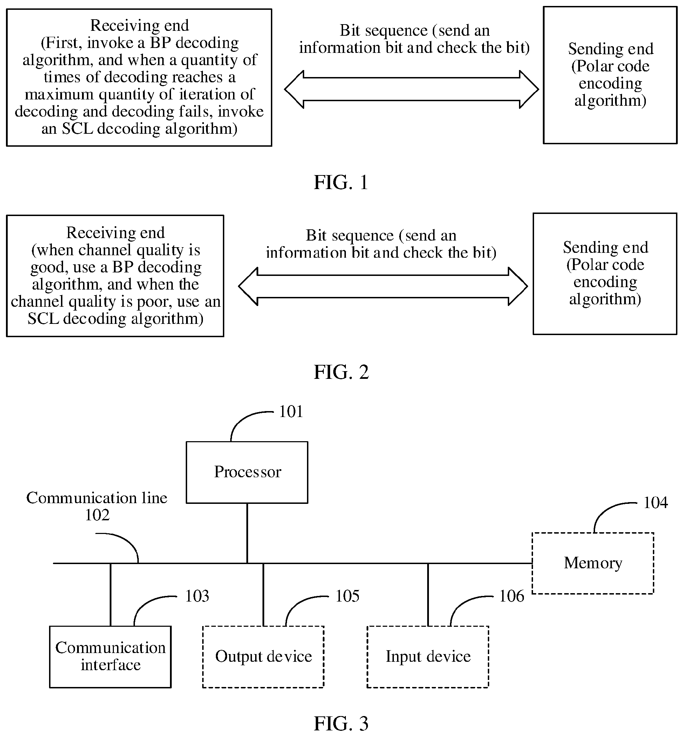

In some examples, the receiving end first invokes the BP decoding algorithm to decode the bit sequence, to obtain the decoding result. The receiving end further checks the decoding result, and if the check succeeds, it is determined that current decoding succeeds. If the check fails, it is determined that the current decoding fails, and the receiving end continues to invoke the BP decoding algorithm to decode the bit sequence until a maximum quantity of iterations of decoding of the BP decoding algorithm is reached. If the decoding still fails after the maximum quantity of iterations of decoding is reached, the receiving end invokes the SCL decoding algorithm to decode the bit sequence. As shown in FIG. 1, the receiving end first invokes the BP decoding algorithm for decoding, and when a quantity of decoding of the BP decoding algorithm reaches the maximum quantity of iteration times of decoding and decoding fails, invokes the SCL decoding algorithm for decoding. That is, invoking sequences of the BP decoding algorithm and the SCL decoding algorithm are fixed, and the decoding algorithm cannot be adaptively selected according to a channel quality. In addition, when the channel quality is relatively poor, a possibility that the BP decoding algorithm fails is high. However, the receiving end still first invokes the BP decoding algorithm, and invokes the SCL decoding algorithm after performing decoding for the maximum quantity of iterations, increasing the decoding delay, so as to reduce communication reliability.

Some embodiments of this application provide a decoding method and an apparatus. The decoding method and the apparatus may estimate a channel quality of the control channel, select a first decoding algorithm when the channel quality meets a first condition, and select a second decoding algorithm when the channel quality meets a second condition, where the channel quality in which the first condition is met is better than the channel quality in which the second condition is met, a decoding delay of the first decoding algorithm is less than a decoding delay of the second decoding algorithm, and decoding reliability of the first decoding algorithm is less than decoding reliability of the second decoding algorithm, so as to adaptively select the decoding algorithm according to the channel quality of the control channel.

As shown in FIG. 2, when the channel quality is relatively better (good), selecting the first decoding algorithm whose decoding reliability is relatively poor but whose decoding delay is small; and when the channel quality is relatively poor, selecting the second decoding algorithm whose decoding reliability is relatively good but whose decoding delay is large. Although the decoding reliability of the first decoding algorithm is poor, when the channel quality is relatively good, a quantity of error information in the bit sequence is relatively small, and the first decoding algorithm can correct the error information in time, and complete decoding by using as few iterations as possible. In this way, when the channel quality is relatively good, the decoding reliability can be ensured and the decoding delay can be reduced. Although the decoding delay of the second decoding algorithm is large, the decoding reliability of the second decoding algorithm is good, so that the second decoding algorithm can correct the error information in the bit sequence in time, and complete decoding in a relatively short time. In this way, when the channel quality is relatively poor, the decoding reliability is improved and the decoding delay is reduced. Therefore, the receiving end can improve the decoding reliability and reduce the decoding delay by adaptively selecting the decoding algorithm, thereby improving communication reliability.

In some embodiments, the foregoing receiving end be a terminal, or also a network side device. The network side device may be an apparatus deployed in a network to provide a wireless communication function for a terminal, for example, the network side device may be a base station. The base station may include a plurality of forms, for example, a macro base station, a micro base station (also referred to as a small cell), a relay station, and an access point (access point). In systems using different radio access technologies, names of the network side device may be different, for example: a base transceiver station (base transceiver station, BTS) in a global system for mobile communications (global system for mobile communication, GSM) or a code division multiple access (code division multiple access, CDMA) network, an NB (NodeB) in a wideband code division multiple access (wideband code division multiple access, WCDMA), an eNB or eNodeB (evolutional NodeB) in a long term evolution (long term evolution, LTE), or a base station in a 5G network or a future evolved public land mobile network (public land mobile network, PLMN). The network side device may also be a broadband network gateway (broadband network gateway, BNG), an aggregation switch, or a non-3GPP network device. In addition, the network side device may also be a radio controller in a cloud radio access network (cloud radio access network, CRAN), a transmission and reception point (transmission and reception point, TRP), a device including a TRP, or the like. This is not specifically limited in the embodiment of this application.

The terminal in the embodiments of this application may be a device with a wireless transceiver function, and may be deployed on land, including indoor or outdoor, handheld or vehicle-mounted, may be deployed on water (for example, on a ship), or may be deployed in the air (for example, on an airplane, a balloon, or a satellite). The terminal may be a user equipment (user equipment, UE), an access terminal, a terminal unit, a subscriber unit (subscriber unit), a terminal station, a mobile station (mobile station, MS), a mobile console, a remote station, a remote terminal, a mobile device, a wireless communication device, a terminal agent, a terminal apparatus, or the like in the 5G network or the future evolved public land mobile network. The access terminal may be a cellular phone (cellular phone), a cordless phone, a session initiation protocol (session initiation protocol, SIP) phone, a wireless local loop (wireless local loop, WLL) station, a personal digital assistant (personal digital assistant, PDA), a handheld device with a wireless communication function, a computing device or another processing device connected to a wireless modem, an in-vehicle device or a wearable device, a virtual reality (virtual reality, VR) terminal, an augmented reality (augmented reality, AR) terminal, a wireless terminal in industrial control (industrial control), a wireless terminal in self driving (self driving), a wireless terminal in remote medical (remote medical), a wireless terminal in a smart grid (smart grid), a wireless terminal in transportation safety (transportation safety), a wireless terminal in a smart city (smart city), a wireless terminal in a smart home (smart home), or the like. The terminal may be mobile or fixed. A specific type and structure of the terminal are not limited in the embodiments of this application.

Optionally, the terminal and the network side device in the embodiment of this application may use a composition structure shown in FIG. 3 or include a component shown in FIG. 3. FIG. 3 is a diagram of a structure of a communication apparatus according to an embodiment of this application. The communication apparatus includes one or more processors 101, a communication line 102, and at least one communication interface (in FIG. 3, only an example in which a communication interface 103 and one processor 101 are included is used for description), and optionally, may further include a memory 104.

The processor 101 may be a central processing unit (central processing unit, CPU), a microprocessor, an application-specific integrated circuit (application-specific integrated circuit, ASIC), or one or more integrated circuits configured to control execution of a program in the solutions of this application.

The communication line 102 may include a channel used for communication between different components.

The communication interface 103 may be configured to communicate with another device or communication network, for example, an Ethernet, a radio access network (radio access network, RAN), a wireless local region network (wireless local region networks, WLAN). For example, the transceiver module may be an apparatus such as a transceiver or a transceiver machine. Optionally, the communication interface 103 may also be a transceiver circuit located in the processor 101, to implement signal input and signal output of the processor.

The memory 104 may be an apparatus with a storage function. For example, the memory may be a read-only memory (read-only memory, ROM) or another type of static storage device that can store static information and instructions, or a random access memory (random access memory, RAM) or another type of dynamic storage device that can store information and instructions, or may be an electrically erasable programmable read-only memory (electrically erasable programmable read-only memory, EEPROM), a compact disc read-only memory (compact disc read-only memory, CD-ROM) or another compact disc storage, an optical disc storage (including a compact disc, a laser disc, an optical disc, a digital versatile disc, a Blu-ray disc, or the like), a magnetic disk storage medium or another magnetic storage device, or any other medium that can be configured to carry or store expected program code in a form of instructions or a data structure and that can be accessed by a computer. However, this is not limited thereto. The memory may exist independently, and may be connected to the processor through the communication line 102. The memory may be also integrated into the processor. The memory 104 is configured to store computer-executable instructions for executing the solutions in this application, and the processor 101 controls the execution. The processor 101 is configured to execute the computer-executable instructions stored in the memory 104 to implement the decoding method provided in the embodiments of this application. Optionally, the computer-executable instructions in the embodiment of this application may also be referred to as application code. This is not specifically limited in the embodiment of this application.

In some examples, the communication apparatus may further include an output device 105 and an input device 106. The output device 105 communicates with the processor 101, and may display information in a plurality of manners. For example, the output device 105 may be a liquid crystal display (liquid crystal display, LCD), a light emitting diode (light emitting diode, LED) display device, a cathode ray tube (cathode ray tube, CRT) display device, a projector (projector), or the like. The input device 106 communicates with the processor 101, and may receive input from a user in a plurality of manners. For example, the input device 106 may be a mouse, a keyboard, a touchscreen device, a sensor device, or the like.

The foregoing communication apparatus may be a general-purpose device or a dedicated device. For example, the communication apparatus may be a desktop computer, a portable computer, a network server, a personal digital assistant (personal digital assistant, PDA), a mobile phone, a tablet computer, a wireless terminal, an embedded device, the foregoing terminal, the foregoing network device, or a device with a structure similar to that in FIG. 3. A type of the communication apparatus is not limited in the embodiment of this application.

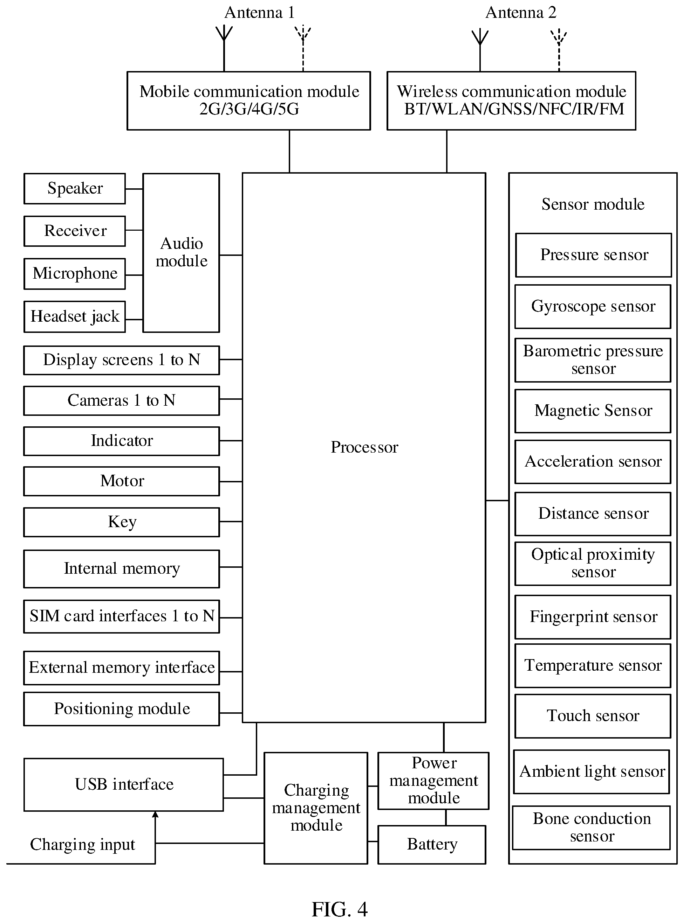

Optionally, FIG. 4 shows an optional hardware structure of a terminal, the terminal may include a processor, an external memory interface, an internal memory, a universal serial bus (universal serial bus, USB) interface, a charging management module, a power management unit, a battery, an antenna 1, an antenna 2, a mobile communication module, a wireless communication module, an audio module, a speaker, a receiver, a microphone, a headset jack, a sensor module, a key, a motor, an indicator, a camera, a display, a subscriber identity module (subscriber identification module, SIM) card interface, and the like. The sensor module may include a pressure sensor, a gyroscope sensor, a barometric pressure sensor, a magnetic sensor, an acceleration sensor, a distance sensor, an optical proximity sensor, a fingerprint sensor, a temperature sensor, a touch sensor, an ambient light sensor, a bone conduction sensor, and the like.

It may be understood that the structure illustrated in this embodiment does not constitute a specific limitation on the terminal. In some other embodiments, the terminal may include more or fewer components than those shown in the figure, some components may be combined, some components may be split, or a different component deployment may be used. The component shown in the figure may be implemented by hardware, software, or a combination of software and hardware.

The processor may include one or more processing units. For example, the processor may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, and/or a neural-network processing unit (neural-network processing unit, NPU). Different processing units may be independent devices, or may be integrated into one or more processors. For example, in the embodiment of this application, the processor may adaptively select the decoding algorithm according to the channel quality of the control channel. For example, the processor selects the first decoding algorithm when the channel quality meets a first condition, and selects the second decoding algorithm when the channel quality meets the second condition. The channel quality when the first condition is met is better than the channel quality when the second condition is met, the decoding delay of the first decoding algorithm is less than the decoding delay of the second decoding algorithm, and the decoding reliability of the first decoding algorithm is less than the decoding reliability of the second decoding algorithm. For example, in some examples, the first decoding algorithm may be the BP decoding algorithm, and the second decoding algorithm may be the SCL decoding algorithm. The controller may be a nerve center and a command center of the terminal. The controller may generate an operation control signal according to instruction operation code and a timing signal, to complete control of instruction fetching and instruction execution. The processor may be further arranged with a memory for storing instructions and data. In some embodiments, the memory in the processor is a cache. The memory may store instructions or data just used or cyclically used by the processor. If the processor needs to use the instruction or the data again, the processor may directly invoke the instruction or the data from the memory, avoiding repeated access and reduces a waiting time of the processor, thereby improving system efficiency.

A wireless communication function of the terminal may be implemented by using the antenna 1, the antenna 2, the mobile communication module, the wireless communication module, the modem processor, the baseband processor, and the like. In some embodiments, the antenna 1 of the terminal is coupled to the mobile communication module, and the antenna 2 is coupled to the wireless communication module, so that the terminal can communicate with a network and another device by using a wireless communication technology.

The terminal implements a display function by using the GPU, the display screen, the application processor, and the like. The GPU is a microprocessor for image processing, and is connected to the display screen and the application processor. The GPU is configured to perform mathematical and geometric computing for graphics rendering. The processor may include one or more GPUs, which execute program instructions to generate or change display information. The terminal may implement a shooting function by using the ISP, the camera, the video codec, the GPU, the display screen, the application processor, and the like.

The external memory interface may be configured to be connected to an external storage card such as a micro SD card, to extend a storage capability of the terminal. The external memory card communicates with the processor through the external memory interface, to implement a data storage function. For example, files such as music and videos are stored in the external memory card.

The internal memory may be configured to store a computer-executable program code, and the executable program code includes instructions. The processor executes the instructions stored in the internal memory, to perform various function applications and data processing of the terminal. For example, in this embodiment, the processor may select a decoding algorithm by executing the instructions stored in the internal memory The internal memory may include a program storage region and a data storage region. The program storage region may store an operating system, an application required by at least one function (for example, a sound playing function and an image playing function), and the like. The data storage region may store data (for example, audio data and an address book) created during use of the terminal, and the like. In addition, the internal memory may include a high-speed random access memory, or may include a non-volatile memory, for example, at least one magnetic disk storage device, a flash memory device, or a universal flash storage (universal flash storage, UFS). The processor runs the instructions stored in the internal memory and/or the instructions stored in the memory disposed in the processor, to implement various functional applications and data processing of the terminal.

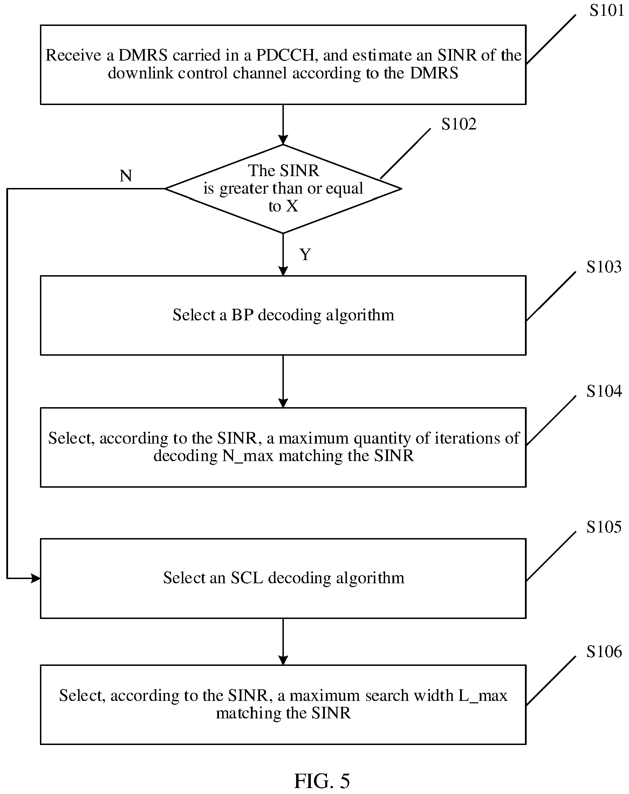

The decoding method provided in the embodiments of this application is described below by using an example in which the receiving end may be the terminal, the first decoding algorithm may be the BP decoding algorithm, and the second decoding algorithm may be the SCL decoding algorithm. FIG. 5 is an optional flowchart of a decoding method according to an embodiment of this application. The method may include the following steps.

S101: The terminal receives a demodulation reference signal (Demodulation Reference Signal, DMRS) carried in a physical downlink control channel (Physical Downlink Control Channel, PDCCH), and estimates a signal to interference plus noise ratio (Signal to Interference plus Noise Ratio, SINR) of the physical downlink control channel according to the DMRS.

In this embodiment, the terminal represents channel quality of the physical downlink control channel by using the SINR of the physical downlink control channel. A larger SINR of the physical downlink control channel indicates better channel quality of the physical downlink control channel, and a smaller SINR of the physical downlink control channel indicates poorer channel quality of the physical downlink control channel.

Better channel quality indicates a smaller quantity of pieces of error information in a bit sequence received by the terminal, so that the terminal may invoke a decoding algorithm whose decoding reliability is poor but decoding delay is small for decoding. Although the decoding algorithm invoked by the terminal has poor decoding reliability, a quantity of pieces of error information in the bit sequence is relatively small, and a possibility of correcting the error information by using the decoding algorithm may be relatively high and time for correcting the error information is relatively short. Therefore, when the channel quality is good, the terminal may invoke the decoding algorithm whose decoding reliability is poor. Poor channel quality indicates a large quantity of pieces of error information in the bit sequence received by the terminal. In this case, the terminal may invoke a decoding algorithm whose decoding reliability is good but decoding delay is large, to correct the error information in the bit sequence in time.

For example, decoding reliability of a BP decoding algorithm is less than decoding reliability of an SCL decoding algorithm, but a decoding delay of the BP decoding algorithm is less than a decoding delay of the SCL decoding algorithm. Therefore, when the channel quality is relatively good, the terminal may invoke the BP decoding algorithm. When the channel quality is relatively poor, the terminal may invoke the SCL decoding algorithm. The BP decoding algorithm and the SCL decoding algorithm are merely examples, and the decoding algorithm invoked by the terminal is not limited in this embodiment.

S102: Determine whether the SINR is greater than or equal to a preset threshold X, and if the SINR is greater than or equal to the preset threshold X, perform step S103; or if the SINR is less than the preset threshold X, perform step S105.

When the channel quality is represented by using the SINR, the terminal may set the preset threshold X, to divide, by using the preset threshold X, SINRs for invoking different decoding algorithms, that is, divide a plurality of SINRs by using the preset threshold X, to obtain a correspondence between an SINR and a decoding algorithm, and select, according to the correspondence between an SINR and a decoding algorithm, a decoding algorithm matching an SINR.

For example, according to a rule that a larger SINR indicates better channel quality and a smaller SINR indicates poorer channel quality, if the SINR is greater than or equal to the preset threshold X, it indicates that the channel quality is relatively good, and the terminal may perform step S103 to select the BP decoding algorithm. If the SINR is less than the preset threshold X, it indicates that the channel quality is relatively poor, and the terminal may perform step S105 to select the SCL decoding algorithm.

S103: Select the BP decoding algorithm. After selecting the BP decoding algorithm, the terminal invokes the BP decoding algorithm for decoding.

S104: Select, according to the SINR, a maximum quantity of iterations of decoding N_max matching the SINR. The maximum quantity of iterations of decoding N_max may be a maximum quantity of times that the terminal invokes the BP decoding algorithm for decoding. Each time the terminal invokes the BP decoding algorithm for decoding, the terminal may check a decoding result, and if the check on the decoding result succeeds, the decoding ends, even if a quantity of times of decoding of the terminal is less than the maximum quantity of iterations of decoding N_max. If the check on the decoding result fails, the terminal may continue to invoke the BP decoding algorithm for decoding until the quantity of times of decoding reaches (is equal to) the maximum quantity of iterations of decoding N_max. In some examples, the terminal may check the decoding result by invoking a cyclic redundancy check (cyclic redundancy check, CRC) algorithm.

When the channel quality is better, the quantity of pieces of error information in the bit sequence is smaller, and when the quantity of pieces of error information in the bit sequence is smaller, the terminal can correct the error information by invoking the BP decoding algorithm for a relatively small quantity of times. Therefore, when the SINR is larger, the maximum quantity of iterations of decoding N_max selected by the terminal is smaller, and when the SINR is smaller, the maximum quantity of iterations of decoding N_max selected by the terminal is larger. According to the rule, the terminal can select, according to the SINR, the maximum quantity of iterations of decoding N_max matching the SINR, so that the terminal can properly invoke the BP decoding algorithm, to successfully perform decoding as much as possible when invoking the BP decoding algorithm.

S105: Select the SCL decoding algorithm. After selecting the SCL decoding algorithm, the terminal invokes the SCL decoding algorithm for decoding.

S106: Select, according to the SINR, a maximum search width L_max matching the SINR.

The maximum search width L_max may be a quantity of candidate paths reserved when the terminal invokes the SCL decoding algorithm for decoding. The terminal may select a path having a smallest path metric value (Path Metrics, PM) from the quantity of candidate paths as a unique path, and marks of edges from a root node to a last leaf node in the unique path form a decoding result of the SCL decoding algorithm.

When the channel quality is worse, the quantity of pieces of error information in the bit sequence is larger, and the maximum search width L_max of the SCL decoding algorithm needs to be larger. In this way, a possibility of successful decoding of the SCL decoding algorithm is larger. Therefore, when the SINR is larger, the maximum search width L_max selected by the terminal is smaller, and when the SINR is smaller, the maximum search width L_max selected by the terminal is larger. According to the rule, the terminal may select, according to the SINR, the maximum search width L_max matching the SINR, so that the terminal can properly invoke the SCL decoding algorithm, to successfully perform decoding as much as possible when invoking the SCL decoding algorithm.

In some examples, the terminal may preset a correspondence between the SINR, the preset threshold X, the decoding algorithm, the maximum search width L_max, and the maximum quantity of iterations of decoding N_max. After estimating the SINR of the physical downlink control channel, the terminal may determine, by using the correspondence, the decoding algorithm and the maximum search width L_max or the maximum quantity of iterations of decoding N_max matching the SINR.

Table 1 shows a preset correspondence among the SINR, the preset threshold X, the decoding algorithm, the maximum search width L_max, and the maximum quantity of iterations of decoding N_max. The preset threshold X may be 16. When the SINR is greater than or equal to 16, the terminal selects the BP decoding algorithm. When the SINR is within [16, 18], the maximum quantity of iterations of decoding N_max is 5. When the SINR is within [19, 21], the maximum quantity of iterations of decoding N_max is 4. When the SINR is within [22, 25], the maximum quantity of iterations of decoding N_max is 3. When the SINR is greater than 25, the maximum quantity of iterations of decoding N_max is 2.

When the SINR is less than 16, the terminal selects the SCL decoding algorithm. When the SINR is within [12, 15], the maximum search width L_max is 1. When the SINR is within [9, 11], the maximum search width L_max is 2. When the SINR is within [4, 8], the maximum search width L_max is 4,. When the SINR is less than 4, the maximum search width L_max is 8.

After estimating the SINR of the physical downlink control channel according to the DMRS, the terminal may select a decoding algorithm with reference to Table 1. After determining that the decoding algorithm is the BP decoding algorithm, the terminal selects the maximum quantity of iterations of decoding N_max with reference to Table 1 according to a range within which the SINR falls. After determining that the decoding algorithm is the SCL decoding algorithm, the terminal selects the maximum search width L_max with reference to Table 1 according to a range within which the SINR falls.

**Table 1: Correspondence among an SINR, a preset threshold X, a decoding algorithm, a maximum search width L_max, and a maximum quantity of iterations of decoding N_max.**

| | |
|---|---|
| SINR preset threshold X | decoding algorithm maximum search width L_max |
| <4 | |
| 16 | |
| SCL decoding algorithm | 8 |
| 4-8 | 4 |
| 9-11 | 2 |
| 12-15 | 1 |
| SINR preset threshold X | decoding algorithm maximum quantity of iterations of decoding N_max |
| 16-18 | |
| 16 | |
| BP decoding algorithm | 5 |
| 19-21 | 4 |
| 22-25 | 3 |
| >25 | 2 |

Table 1 is merely an example. In this embodiment, the correspondence among the SINR, the preset threshold X, the decoding algorithm, the maximum search width L_max, and the maximum quantity of iterations of decoding N_max is not limited, and may be adjusted according to an actual engineering value.

It can be learned from the decoding method shown in FIG. 5 that, when the channel quality is relatively good, the terminal may select the BP decoding algorithm, and when the channel quality is relatively poor, the terminal may select the SCL decoding algorithm. Although the decoding reliability of the BP decoding algorithm is relatively poor, when the channel quality is relatively good, the quantity of pieces of error information in the bit sequence is relatively small, and the error information can be corrected in time by using the BP decoding algorithm. When the channel quality is better, the maximum quantity of iterations of decoding N_max of the BP decoding algorithm is smaller, so that the terminal can complete decoding by using as few iterations as possible. In this way, when the channel quality is relatively good, the decoding reliability can be ensured and the decoding delay can be reduced. Although the decoding delay of the SCL decoding algorithm is large, the decoding reliability of the SCL decoding algorithm is good, so that the error information in the bit sequence can be corrected in time by using the SCL decoding algorithm, and decoding is completed in a relatively short time. In this way, when the channel quality is relatively poor, the decoding reliability is improved and the decoding delay is reduced. Therefore, the terminal can improve the decoding reliability and reduce the decoding delay by adaptively selecting the decoding algorithm, thereby improving the communication reliability.

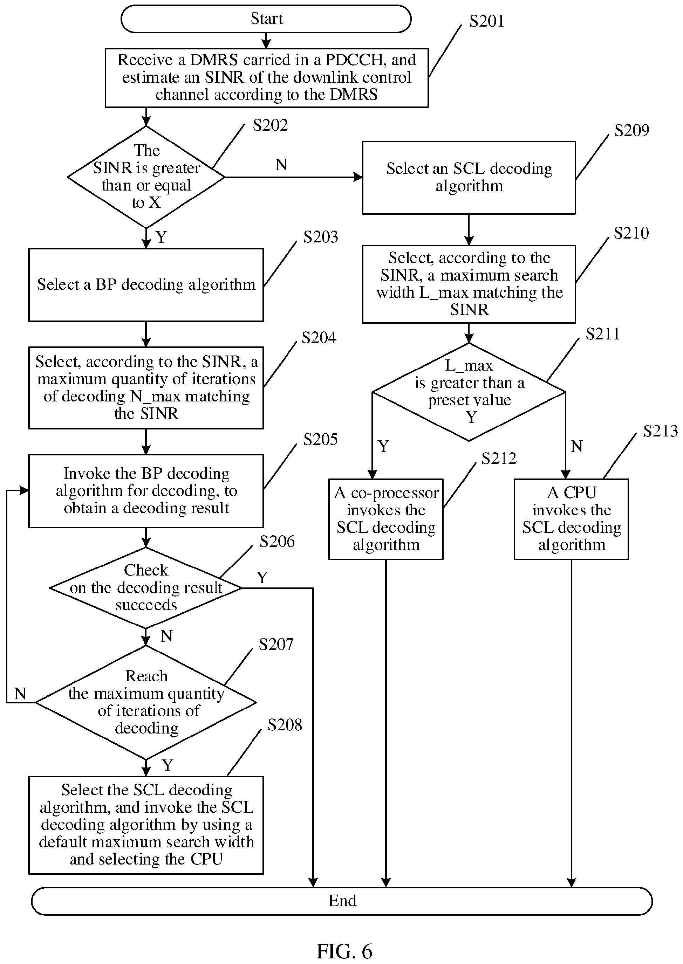

FIG. 6 is an optional flowchart of another decoding method according to an embodiment of this application. The method may include the following steps.

S201: A terminal receives a DMRS carried in a PDCCH, and estimates an SINR of the physical downlink control channel according to the DMRS.

S202: Determine whether the SINR is greater than or equal to a preset threshold X, and if the SINR is greater than or equal to the preset threshold X, perform step S203; or if the SINR is less than the preset threshold X, perform step S209.

S203: Select a BP decoding algorithm.

S204: Select, according to the SINR, a maximum quantity of iterations of decoding N_max matching the SINR.

S205: Invoke the BP decoding algorithm for decoding, to obtain a decoding result.

S206: Determine whether check on the decoding result succeeds, and if the check on the decoding result succeeds, end the process; or if the check on the decoding result fails, perform step S207.

S207: Determine whether a quantity of iterations reaches the maximum quantity of iterations of decoding, and if the quantity of iterations reaches the maximum quantity of iterations of decoding, perform step S208; or if the quantity of iterations does not reach the maximum quantity of iterations of decoding, return to step S205.

S208: Select an SCL decoding algorithm, and invoke the SCL decoding algorithm by using a default maximum search width L_max and selecting a CPU.

S209: Select the SCL decoding algorithm.

S210: Select, according to the SINR, a maximum search width L_max matching the SINR.

S211: Determine whether the maximum search width L_max is greater than a preset value, and if the maximum search width L_max is greater than the preset value Y, perform step S212; or if the maximum search width L_max is less than or equal to the preset value Y, perform step S213.

S212: A co-processor invokes the SCL decoding algorithm.

S213: The CPU invokes the SCL decoding algorithm.

Compared with the foregoing decoding method shown in FIG. 5, a difference between the decoding method shown in FIG. 6 and the decoding method shown in FIG. 5 lies in that in a process in which the terminal invokes the BP decoding algorithm for decoding, the terminal may perform decoding by using the CPU. If the quantity of iterations reaches (is equal to) the maximum quantity of iterations of decoding N_max and the check on the decoding result fails, the terminal may select the SCL decoding algorithm. When the SCL decoding algorithm is invoked, the default maximum search width L_max is used. In other words, after the BP decoding algorithm fails, if the SCL decoding algorithm is invoked, the maximum search width L_max of the SCL decoding algorithm may be fixed, and does not change with a change of the SINR.

A scenario in which the SCL decoding algorithm is invoked after the BP decoding algorithm fails is a scenario in which channel quality is relatively good. A quantity of pieces of error information in a bit sequence is relatively small in this scenario. Therefore, the terminal does not need to use the relatively complex SCL decoding algorithm. In this case, the default maximum search width L_max of the SCL decoding algorithm may use a relatively small value. For example, the default maximum search width L_max may be 1. In addition, the terminal may complete decoding by using the CPU, and the CPU invokes the SCL decoding algorithm for decoding.

In a scenario in which the terminal selects the SCL decoding algorithm according to the SINR, in addition to selecting the matching maximum search width L_max according to the SINR, the terminal further determines, according to a relationship between the maximum search width L_max and the preset value Y, whether to accelerate the decoding process, so that the terminal can complete decoding as soon as possible.

The preset value Y may be the maximum search width L_max used when the terminal does not perform acceleration processing on the decoding process. Therefore, when the maximum search width L_max is greater than the preset value Y, the terminal performs acceleration processing on the decoding process. When the maximum search width L_max is less than or equal to the preset value Y, the terminal does not perform acceleration processing on the decoding process.

In some examples, a manner in which the terminal accelerates the decoding process may be: The terminal performs decoding by using the co-processor, and the co-processor invokes the SCL decoding algorithm for decoding. The co-processor may be, but is not limited to, a GPU, a field programmable gate array (field programmable gate array, FPGA) circuit, a DSP, an ASIC, or another hardware accelerator. A manner in which the terminal does not accelerate the decoding process may be: the terminal performs decoding by using the CPU, and the CPU invokes the SCL decoding algorithm for decoding. Because a larger maximum search width L_max of the SCL decoding algorithm indicates larger complexity of the SCL decoding algorithm and more computing resources needed by the SCL decoding algorithm, when the maximum search width L_max is greater than the preset value Y, decoding is performed by using the co-processor having a better computing capability, to accelerate decoding, so that the terminal completes decoding as soon as possible.

Table 2 shows an example of the preset value Y. The preset value Y may be 4. When the maximum search width L_max is 8, the maximum search width L_max is greater than the preset value Y, and a processor is the co-processor, to accelerate decoding. When the maximum search width L_max is 4, the maximum search width L_max is equal to the preset value Y, and the processor is the CPU, and does not accelerate decoding. When the maximum search width L_max is 2 or 1, the maximum search width L_max is equal to the preset value Y, and the processor is the CPU, and does not accelerate decoding.

**Table 2: Correspondence among an SINR, a preset threshold X, a decoding algorithm, a maximum search width L_max, a maximum quantity of iterations of decoding N_max, and a processor**

| | |
|---|---|
| SINR preset threshold X | decoding algorithm maximum search width L_max preset value Y processor |
| <4 | |
| 16 | |
| SCL decoding algorithm | 8 |
| 4 Processor | |
| 4-8 | 4 |
| CPU | |
| 9-11 | 2 |
| 12-15 | 1 |
| SINR preset threshold X | decoding algorithm maximum quantity of iterations N_max |
| 16-18 | |
| 16 | |
| BP decoding algorithm | 5 |
| 19-21 | 4 |
| 22-25 | 3 |
| >25 | 2 |

Table 2 is merely an example. The preset value Y is not limited in this embodiment, and may be adjusted according to an actual engineering value.

It can be learned from the decoding method shown in FIG. 6 that when the channel quality is relatively poor, the terminal may determine, according to the relationship between the maximum search width L_max and the preset value Y, whether to accelerate decoding. For example, when the maximum search width L_max is relatively large, the terminal may perform decoding by using the co-processor, to accelerate decoding, so that the terminal can complete decoding as soon as possible when using the SCL decoding algorithm with relatively large complexity.

It should be noted herein that in the foregoing decoding methods shown in FIG. 5 and FIG. 6, the decoding algorithm is selected according to the relationship between the SINR and the preset threshold X. In the decoding method shown in FIG. 6, the processor may be further selected according to the relationship between a maximum search width L_max and the preset value Y. These are merely examples. According to the decoding method provided in some embodiments of this application, a decoding algorithm may be selected according to a relationship between an SINR and a decoding algorithm, and a processor may be selected according to a relationship between a maximum search width L_max and a processor. For example, the terminal may separately attempt to invoke the BP decoding algorithm and the SCL decoding algorithm for decoding under a same SINR, to test an effect of performing decoding by using different decoding algorithms in the same SINR, and configure a decoding algorithm for the SINR according to a tested effect (for example, an effect of a plurality of tests). When attempting to invoke the SCL decoding algorithm, the terminal may separately attempt to perform decoding by using a co-processor and a CPU, to test an effect of performing decoding by using different processors in the same SINR, and configure a processor for the SCL decoding algorithm in the SINR according to a tested effect (for example, an effect of a plurality of tests). After completing the configuration, the terminal obtains the relationship between an SINR and a decoding algorithm, and the relationship between a maximum search width L_max and a processor. Certainly, the terminal may also obtain a relationship between a BP decoding algorithm and a maximum quantity of iterations of decoding N_max, and a relationship between an SCL decoding algorithm and a maximum search width L_max through a plurality of tests. Details are not described herein again.

With reference to Table 2, the decoding method provided in the embodiments of this application is described below with reference to a specific example.

Example 1: In a scenario in which channel quality is relatively good, the preset threshold X is equal to 15, and the decoding process is as follows.
1: The terminal estimates a DMRS carried in a PDCCH, and obtains an SINR of 22.
2: Search Table 2 according to the SINR, select a BP decoding algorithm, and determine that a maximum quantity of iterations of decoding N_max is 3.
3: After invoking the BP decoding algorithm and completing decoding, check a decoding result, and if the check on the decoding result succeeds, determine that the decoding succeeds, exit the decoding in advance, and end the decoding. If the check on the decoding result fails, the BP decoding algorithm continues to be invoked for decoding.
4: Determine whether a quantity of times of decoding reaches a maximum quantity of iterations of decoding N_max, and if the quantity of times of decoding reaches the maximum quantity of iterations of decoding N_max and decoding fails, select an SCL decoding algorithm, where a maximum search width L_max of the SCL decoding algorithm is a default value, and a CPU performs decoding.

Example 2: In a scenario in which channel quality is relatively poor, the preset threshold X is equal to 12, the preset value Y is equal to 4, and the decoding process is as follows.
11: The terminal estimates a DMRS carried in a PDCCH, and obtains an SINR of 8;
12: Search Table 2 according to the SINR, select an SCL decoding algorithm, and determine that a maximum search width L_max is 4.
13: Because L_max=Y, select a CPU for decoding, and skip accelerating the decoding process.

Example 3: In a scenario in which channel quality is very poor, the preset threshold X is equal to 12, the preset value Y is equal to 4, and the decoding process is as follows.
21: The terminal estimates a DMRS carried in a PDCCH, and obtains an SINR of 3.
22: Search Table 2 according to the SINR, select an SCL decoding algorithm, and determine that a maximum search width L_max is 8.
23: Because L_max>Y, select a co-processor for decoding, and accelerate the decoding process.

It can be learned from the foregoing examples that, according to the decoding method provided in the embodiments of this application, the BP decoding algorithm or the SCL decoding algorithm can be adaptively selected based on the SINR representing the channel quality for decoding. If the BP decoding algorithm is selected, a quantity of times of decoding reaches the maximum quantity of iterations of decoding and decoding fails, the SCL decoding algorithm is selected for decoding. Further, after the SCL decoding algorithm is selected based on the SINR, whether to perform decoding acceleration may be further selected according to the maximum search width L_max of the SCL decoding algorithm.

The foregoing embodiment is described by using an example in which the receiving end may be the terminal. The decoding method provided in the embodiments of this application may alternatively be applied to a network side device, and a difference between the decoding method applied to the network side device and the decoding method applied to the terminal lies in tha: the network side device may receive a DMRS carried in a physical uplink control channel (Physical Uplink Control Channel, PUCCH), and estimate an SINR of the physical uplink control channel according to the DMRS. A process of the decoding method implemented by the network side device is as follows.
(1) The network side device receives the DMRS carried in the PUCCH, and estimates the SINR of the PUCCH according to the DMRS.
(2) Determine whether the SINR is greater than or equal to a preset threshold X, and if the SINR is greater than or equal to the preset threshold X, perform (3); or if the SINR is less than the preset threshold X, perform (9).
(3) Select a BP decoding algorithm.
(4) Select, according to the SINR, a maximum quantity of iterations of decoding N_max matching the SINR.
(5) Invoke the BP decoding algorithm for decoding, to obtain a decoding result.
(6) Determine whether check on the decoding result succeeds, and if the check on the decoding result succeeds, end the process; or if the check on the decoding result fails, perform (7).
(7) Determine whether a quantity of iterations reaches the maximum quantity of iterations of decoding, and if the quantity of iterations reaches the maximum quantity of iterations of decoding, perform (8); or if the quantity of iterations does not reach the maximum quantity of iterations of decoding, return to (5).
(8) Select an SCL decoding algorithm, and invoke the SCL decoding algorithm by using a default maximum search width L_max and selecting a CPU.
(9) Select the SCL decoding algorithm.
(10) Select, according to the SINR, the maximum search width L_max matching the SINR.
(11) Determine whether the maximum search width L_max is greater than a preset value, and if the maximum search width L_max is greater than the preset value Y, perform (12); or if the maximum search width L_max is less than or equal to the preset value Y, perform (13).
(12) A co-processor invokes the SCL decoding algorithm.
(13) The CPU invokes the SCL decoding algorithm.

The embodiment of this application further provides a receiving end device. The receiving end device includes one or more processors and a memory, where the memory is configured to store computer program code, the computer program code includes computer instructions, and when the one or more processors execute the computer instructions, the receiving end device performs the foregoing decoding method.

The embodiment of this application further provides a computer-readable storage medium, where the computer-readable storage medium is configured to store a computer program, and the computer program, when being executed, implements the foregoing decoding method.

The embodiment of this application further provides a chip system, used in a receiving end device, where the chip system includes at least one processor and an interface, the interface is configured to receive instructions, and transmit the instructions to the at least one processor, and the at least one processor runs the instructions, so that the receiving end device performs the foregoing decoding method.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A decoding method, applied to a receiving end device, wherein a control channel is established between the receiving end device and a sending end device, and the decoding method comprises:
receiving a demodulation reference signal sent by the sending end device through the control channel;
estimating channel quality of the control channel according to the demodulation reference signal;
selecting a first decoding algorithm when the channel quality of the control channel meets a first condition; and
selecting a second decoding algorithm when the channel quality of the control channel meets a second condition, wherein
channel quality meeting the first condition is better than channel quality meeting the second condition, a decoding delay of the first decoding algorithm is less than a decoding delay of the second decoding algorithm, and decoding reliability of the first decoding algorithm is smaller than decoding reliability of the second decoding algorithm.

2. The method according to claim 1, wherein the method further comprises: when the channel quality of the control channel meets the first condition, selecting, according to the channel quality of the control channel, a maximum quantity of iterations of decoding of the first decoding algorithm.

3. The method according to claim 2, wherein a relationship between the channel quality of the control channel and the maximum quantity of iterations of decoding is negative correlation.

4. The method according to claim 2 or 3, wherein the method further comprises: selecting the second decoding algorithm when a quantity of iterations of invoking the first decoding algorithm by the receiving end device is equal to the maximum quantity of iterations of decoding and decoding fails.

5. The method according to claim 4, wherein the receiving end device comprises a first processor and a second processor, a computing capability of the first processor is less than a computing capability of the second processor, and the method further comprises:
when the quantity of iterations of invoking the first decoding algorithm by the receiving end device is equal to the maximum quantity of iterations of decoding and decoding fails, invoking, by the first processor, the second decoding algorithm for decoding, wherein a maximum search width of the second decoding algorithm is a default search width.

6. The method according to any one of claims 1 to 5, wherein the method further comprises: when the channel quality of the control channel meets the second condition, selecting the maximum search width of the second decoding algorithm according to the channel quality of the control channel.

7. The method according to claim 6, wherein a relationship between the channel quality of the control channel and the maximum search width is negative correlation.

8. The method according to claim 6 or 7, wherein the receiving end device comprises the first processor and the second processor, the computing capability of the first processor is less than the computing capability of the second processor, and the method further comprises: determining, in the first processor and the second processor according to the maximum search width of the second decoding algorithm, a processor that invokes the second decoding algorithm.

9. The method according to claim 8, wherein the determining, in the first processor and the second processor according to the maximum search width of the second decoding algorithm, a processor that invokes the second decoding algorithm comprises: determining, when the maximum search width of the second decoding algorithm is greater than a preset value, that the second processor invokes the second decoding algorithm; or
determining, when the maximum search width of the second decoding algorithm is less than or equal to the preset value, that the first processor invokes the second decoding algorithm.

10. The method according to any one of claims 1 to 9, wherein the method further comprises at least one of the following: the receiving end device is a terminal, and the control channel is a physical downlink control channel; or
the receiving end device is a network side device, and the control channel is a physical uplink control channel; or
the channel quality of the control channel is represented by using a signal to interference plus noise ratio of the control channel; or
the first decoding algorithm is a belief propagation decoding algorithm; and or
the second decoding algorithm is a successive cancellation list decoding algorithm.

11. The method according to claim 10, wherein the selecting a first decoding algorithm when the channel quality of the control channel meets a first condition, and selecting a second decoding algorithm when the channel quality of the control channel meets a second condition comprises: selecting the belief propagation decoding algorithm when the signal to interference plus noise ratio of the control channel is greater than or equal to a preset threshold; or
selecting the successive cancellation list decoding algorithm when the signal to interference plus noise ratio of the control channel is less than the preset threshold.

12. The method according to claim 11, wherein the method further comprises: determining a maximum quantity of iterations of decoding of the belief propagation decoding algorithm according to the signal to interference plus noise ratio of the control channel when the signal to interference plus noise ratio of the control channel is greater than or equal to the preset threshold;
and/or
determining a maximum search width of the successive cancellation list decoding algorithm according to the signal to interference plus noise ratio of the control channel when the signal to interference plus noise ratio of the control channel is less than the preset threshold.

13. The method according to claim 12, wherein a preset correspondence table is searched for the maximum quantity of iterations of decoding according to the signal to interference plus noise ratio of the control channel;
and/or
the preset correspondence table is searched for the maximum search width according to the signal to interference plus noise ratio of the control channel.

14. The method according to any one of claims 11 to 13, wherein the receiving end device comprises the first processor and the second processor, the computing capability of the first processor is less than the computing capability of the second processor, and the method further comprises: determining, when the maximum search width of the successive cancellation list decoding algorithm is greater than the preset value, that the second processor invokes the successive cancellation list decoding algorithm; or
determining, when the maximum search width of the successive cancellation list decoding algorithm is less than or equal to the preset value, that the first processor invokes the successive cancellation list decoding algorithm.

15. The method according to any one of claims 5, 8, 9, and 14, wherein the first processor is a central processing unit, and the second processor is a co-processor.

16. The method according to claim 15, wherein the co-processor is any one of a graphics processing unit, a field programmable gate array circuit, a digital signal processor, and an application-specific integrated circuit.

17. A receiving end device, wherein the receiving end device comprises:
one or more processors and a memory, wherein
the memory is configured to store computer program code, the computer program code comprises computer instructions, and when the one or more processors execute the computer instructions, the receiving end device is caused to perform the decoding method according to any one of claims 1 to 16.

18. A computer-readable storage medium, wherein the computer-readable storage medium is configured to store a computer program, and the computer program, when being executed, implements the decoding method according to any one of claims 1 to 16.
